# EUROPEAN PATENT APPLICATION

(11) **EP 2 290 683 A1**
(43) Date of publication of application: **02.03.2011**
(21) Application number: 09168824.2
(22) Date of filing: 27.08.2009
(51) Int. Cl.: H01L 23/498, H01L 23/538, H01L 23/492, H01L 23/13

(54) **Wiring of an electronic module**

(71) Applicant: ABB Research Ltd, 8050 Zürich (CH)
(72) Inventor: Haederli, Christoph, CH-8047, Zürich (CH); Kicin, Slavo, CH-8049, Zürich (CH)
(74) Representative: Brax, Matti Juhani

(57) **Abstract**

An electrical module comprising a first electrically conductive substrate plate (101), a second electrically conductive substrate plate (102), and semiconductor components (103-110) between the first and second substrate plates is presented. The second substrate plate is shaped to have cuts (115, 116, 122, 123, 124) on its edge or apertures for providing access to control terminals of the semiconductor components in order to facilitate connection of wire bonds to the control terminals. Hence, the wire bonds to the control terminals can be made after the semiconductor components have been bonded to the first and second substrate plates. Furthermore, due to the appropriate shaping of the second substrate plate, the area of the second substrate plate does not need to be essentially smaller than that of the first substrate plate. Thus cooling via the second substrate plate is sufficiently balanced with cooling via the first substrate plate and, as a consequence, temperature stresses can be reduced.

## Description

### Field of the invention

The invention relates to an electrical module that comprises two substrate plates and one or more semiconductor components between the substrate plates. Furthermore, the invention relates to a method for fabricating an electrical module of the kind mentioned above. Furthermore, the invention relates to an electrical converter device.

### Background

A double-side cooled electrical module is an attractive concept for a power device since it allows to applying higher currents compared to one-side cooled electrical modules at the same operating temperature. One of the possible designs of the double-side cooled module is an electrical module that comprises two electrically and thermally conductive substrate plates and one or more semiconductor components between the substrate plates in such a manner that main current terminals of the semiconductor components such as e.g. an emitter and a collector of an insulated gate bipolar transistor (IGBT) or an anode and a cathode of a diode are directly bonded to the substrate plates. In addition to providing electrical contacts, these substrate plates have also a function of the thermal contact to heat sinks of the relevant power system and together with them they form a part of the main current circuit of this power system. An advantage of an electrical module of the kind described above is that wire bonds are not needed in the main current circuit since the electrical terminals of semiconductor components are directly bonded to the electrically and thermally conductive substrate plates.

However, wire bonds may still be needed to contact control terminals of the semiconductor components, e.g. gates of IGBTs, to other parts of the relevant power system in order to be able to control the electrical module. The wire bonding is a suitable technique for connecting the control terminals of the semiconductor components since high current loads resulting in a local increase of the temperature are not required during operation. There are, however, certain difficulties related to the wire bonding of the control terminals of the semiconductor components.

The bonding of the main current terminals of the semiconductor components to the substrate plates could require temperatures which could harm the wire bonds of the control terminals. This means that the wire bonds of the control terminals must be done only after the main current terminals have been bonded to the substrate plates. Making the wire bonds after the bonding of the main current terminals to the substrate plates is complicated by the fact that the gap between the substrate plates may be relatively narrow. Furthermore, the main current terminals of the semiconductor components are directly attached to the electrically conductive substrate plates. This means that eventual leads for control signals must be added separately. This is a difference to one-side cooled electrical modules where paths for the control signals are defined on DCB substrates (Direct Copper Bonding) for the semiconductor components.

### Summary

In accordance with the first aspect of the invention, there is provided a new electrical module. The electrical module according to the invention comprises:
- a first electrically conductive substrate plate,
- a second electrically conductive substrate plate,
- one or more semiconductor components between the first and second substrate plates in such a manner that a first main current terminal of each semiconductor component is bonded to the first substrate plate and a second main current terminal of each semiconductor component is bonded to the second substrate plate, and
- one or more wire bonds connected to control terminals of the semiconductor components,
   wherein the second substrate plate has one or more cuts on its edge or one or more apertures for providing access to the control terminals of the semiconductor components in order to facilitate the connection of the wire bonds to the control terminals of the semiconductor components.

The appropriate shaping of the second substrate plate makes it easier and more cost effective to make the wire bonds to the control terminals after the semiconductor components have been bonded to the first and second substrate plates. Furthermore, due to the appropriate shaping of the second substrate plate, the area of the second substrate plate does not need to be essentially smaller than that of the first substrate plate. Thus, cooling via the second substrate plate is still efficient and it is sufficiently balanced around the semiconductor components and, as a consequence, no additional temperature stresses are ensued.

In accordance with the second aspect of the invention, there is provided a new method for fabricating an electrical module. The method according to the invention comprises:
- bonding a first main current terminal of one or more semiconductor components to a first electrically conductive substrate plate,
- bonding a second main current terminal of the one or more semiconductor components to a second electrically conductive substrate plate, and subsequently
- connecting one or more wire bonds to control terminals of the semiconductor components,
   wherein the second substrate plate has one or more cuts on its edge or one or more apertures for providing access to the control terminals of the semiconductor components in order to facilitate the connection of the wire bonds to the control terminals of the semiconductor components.

In accordance with the third aspect of the invention, there is provided a new electrical converter device. The electrical converter device comprises at least one an electrical module according to the invention. The electrical converter device can be, e.g. an inverter, a rectifier, and/or a frequency converter.

A number of exemplifying embodiments of the invention are described in accompanied dependent claims.

Various embodiments of the invention both as to constructions and to methods of operation, together with additional objects and advantages thereof, will be best understood from the following description of specific exemplifying embodiments when read in connection with the accompanying drawings.

The verb "to comprise" is used in this document as an open limitation that neither excludes nor requires the existence of also unrecited features. The features recited in depending claims are mutually freely combinable unless otherwise explicitly stated.

### Brief description of the figures

The exemplifying embodiments of the invention and their advantages are explained in greater detail below in the sense of examples and with reference to the accompanying drawings, in which:
figure 1a shows a top view of an electrical module according to an embodiment of the invention,
figure 1b shows a side view of the electrical module shown in figure 1 a,
figure 1c shows a section view taken along the line A-A of figure 1b,
figure 2a shows a top view of an electrical module according to an embodiment of the invention,
figure 2b shows a side view of the electrical module shown in figure 2a,
figure 3a shows an electrical converter device according to an embodiment of the invention,
figure 3b shows a detail of the electrical converter device shown in figure 3a, and
figure 4 is a flow chart of a method according to an embodiment of the invention for fabricating an electrical module.

### Description of the embodiments

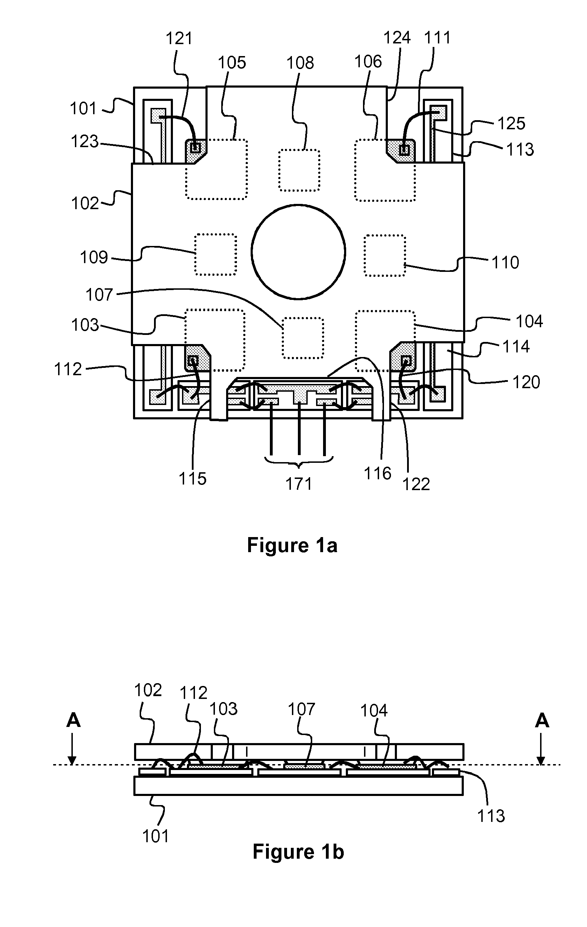

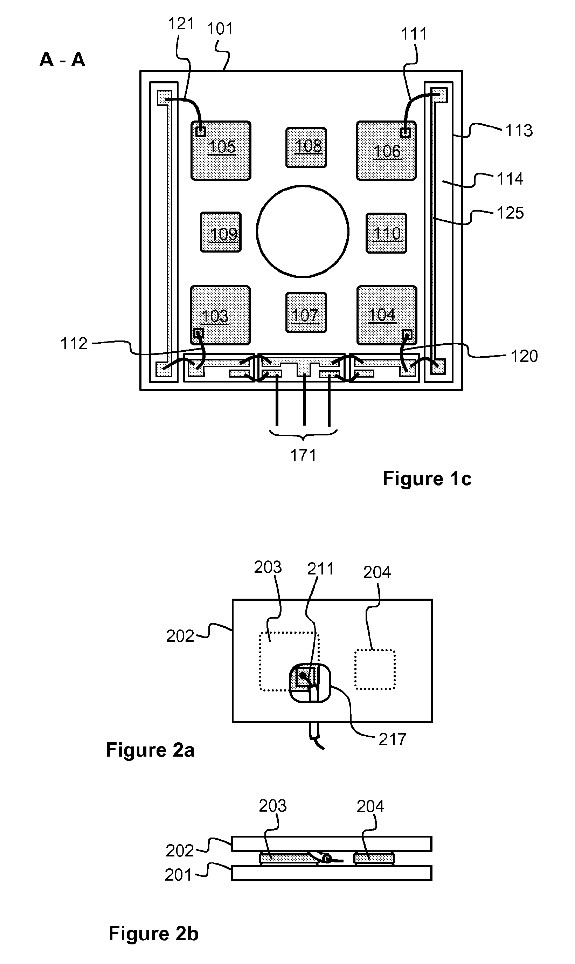

Figure 1 a shows a top view of an electrical module according to an embodiment of the invention and figure 1b shows a side view of the electrical module. Figure 1c shows a section view of the electrical module, wherein the section is taken along the line A-A shown in figure 1 b. The electrical module comprises a first substrate plate 101, a second substrate plate 102, and semiconductor components 103, 104, 105, 106, 107, 108, 109, and 110 between the substrate plates 101 and 102 in such a manner that a first main current terminal of each semiconductor component is bonded to the substrate plate 101 and a second main current terminal of each semiconductor component is bonded to the substrate plate 102. The substrate plates 101 and 102 form a part of a main current path when the electrical module is in use. In addition to providing electrical contacts, the substrate plates 101 and 102 have also a function of the thermal contact to heat sinks of the relevant power system. The substrate plates 101 and 102 can be made of copper or aluminum or of materials with better matched coefficient of thermal expansion in order to mitigate stresses during fabrication of the electrical module, e.g. various metal matrix composites such as for example Al-graphite, AISiC, molybdenum, etc. The electrical module comprises wire bonds 111, 112, 120, and 121 that are connected to control terminals of the semiconductor components 106, 103, 104, and 105, respectively. The substrate plate 102 has cuts 115, 116, 122, 123, and 124 on its edge for providing access to the control terminals of the semiconductor components in order to facilitate the connection of the wire bonds 111, 112, 120, and 121 to the control terminals of the semiconductor components 106, 103, 104, and 105. In the electrical component illustrated in figures 1a-1c, the substrate plate 102 has a shape of a rectangle from which corners have been removed and which has a cut also on the middle of one of its sides.

Each of the semiconductor components 103-110 can be, for example but not necessarily, one of the following: an insulated gate bipolar transistor (IGBT), a field effect transistor (FET), a gate turn-off thyristor (GTO), a thyristor, or a diode. For example, it is possible that the semiconductor components 103-106 are insulated gate bipolar transistors (IGBT) whose collectors are bonded to the substrate plate 101 and emitters are bonded to the substrate plate 102, and the semiconductor components 107-110 are diodes that are anti-parallel to the IGBTs. The gates of the IGBTs are connected to the wire bonds 111, 112, 120, and 121.

The electrical module illustrated in figures 1a-1c comprises wiring structures connected to the wire bonds. Each wiring structure 113 comprises an insulator layer 114 and a metal strip 125 on one side of the insulator layer. The insulator layer of the wiring structure comprises preferably a metal strip/layer also on the opposite side for facilitating the attachment of the wiring structure to the substrate plate. The metal strip can be e.g. of copper or aluminum. The wiring structures are bonded to the same side of the substrate plate 101 as the semiconductor components. The wiring structures are preferably DCB substrates (Direct Copper Bonding) as they withstand temperatures above 200 °C and are thus advantageous from the viewpoint of fabrication of the electrical module. The DCB substrates can be bonded to the substrate plate 101 for example by soldering. Since it is complicated to produce DCB substrates with a complex shape allowing access to more semiconductor components, a solution is to use several smaller DCB substrates with a simple, rectangular shape and connect them electrically together with wire bonds as illustrated in figures 1 a and 1 c. The wiring structures are preferably bonded to the substrate plate 101 in a same fabrication step as the semiconductor components are bonded to the substrate plate 101 but it is also possible to attach DCB substrates during bonding of the semiconductor components to the substrate plate 102.

For another example, the wiring structures can be PCBs (Printed Circuit Board) that are attached to the to the substrate plate 101 with adhesives after the substrate plates 101 and 102 have been bonded to the semiconductor components. The attachment of the PCBs may require certain special tools and/or arrangements due to the fact that the gap between the substrate plates 101 and 102 may be relatively narrow.

In the electrical module shown in figures 1a-1c, the function of the cuts 115, 116, 122, 123, and 124 is:
- providing access to allow connection of control terminal, e.g. gate, contacts of the semiconductor components 106, 103, 104, and 105 and wiring structures using wire bonding technique,
- providing access to allow connection of wiring structures between each other if necessary, and
- providing access to allow connection of terminals 171 for receiving control signals from outside the electrical module.

Figure 2a shows a top view of an electrical module according to another exemplifying embodiment of the invention and figure 2b shows a side view of the electrical module shown in figure 2a. The electrical module comprises a first electrically conductive substrate plate 201, a second electrically conductive substrate plate 202, semiconductor components 203 and 204 between the substrate plates 201 and 202 in such a manner that a first main current terminal of each semiconductor component is bonded to the substrate plate 201 and a second main current terminal of each semiconductor component is bonded to the substrate plate 202. The electrical module comprises a wire bond 211 connected to a control terminal of the semiconductor component 203. The substrate plate 202 has an aperture 217 for providing access to the control terminal of the semiconductor component 203 in order to facilitate the connection of the wire bond to the control terminal. For example, it is possible that the semiconductor component 203 is an insulated gate bipolar transistor (IGBT) whose collector is bonded to the substrate plate 201 and emitter is bonded to the substrate plate 202, and the semiconductor component 204 is a diode that is anti-parallel to the IGBT. The gate of the IGBT is connected to the wire bond 211.

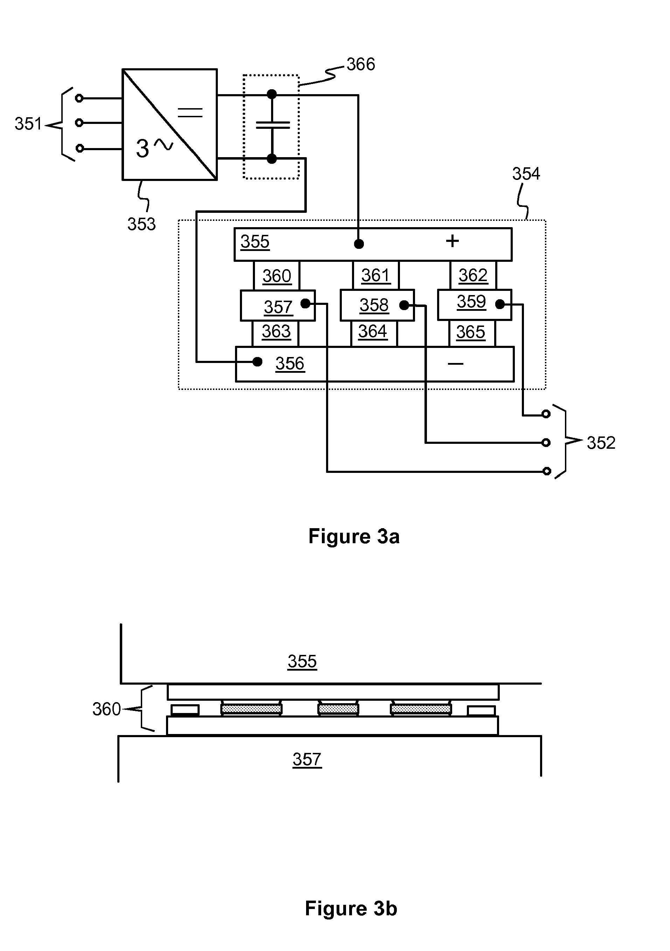

An electrical converter device according to an embodiment of the invention comprises at least one an electrical module according to an embodiment of the invention. Figure 3a shows an electrical converter device according to an embodiment of the invention. The electrical converter device comprises an electrical terminal 351 for connecting the electrical converter device to an alternating voltage network (not shown) and an electrical terminal 352 for connecting the electrical converter device to a load (not shown) that can be e.g. an induction motor. The electrical converter device comprises a converter unit 353 that can be e.g. a rectifier that is arranged to transfer energy from the alternating voltage network to an intermediate circuit 366 of the electrical converter device. The converter unit 353 can be as well a device that is capable of transferring energy not only from the alternating voltage network to the intermediate circuit 366 but also from the intermediate circuit back to the alternating voltage network.

The electrical converter device comprises an inverter bridge 354 that is able to transfer energy from the intermediate circuit 366 to the load and also to transfer energy from the load to the intermediate circuit. The main circuit of the inverter bridge comprises electrical conductor elements 355 and 356 that are connected to the intermediate circuit, and electrical conductor elements 357, 358, and 359 that are connected to different phases of the electrical terminal 352. The main circuit of the inverter bridge comprises electrical modules 360, 361, 362, 363, 364, and 365 that are pressed between the electrical conductor elements 355-359 as shown in figure 3a. Each of the electrical modules 360-365 comprises:
- a first electrically conductive substrate plate,
- a second electrically conductive substrate plate,
- one or more semiconductor components between the first and second substrate plates in such a manner that a first main current terminal of each semiconductor component is bonded to the first substrate plate and a second main current terminal of each semiconductor component is bonded to the second substrate plate, and
- one or more wire bonds connected to control terminals of the semiconductor components,
   wherein the second substrate plate has one or more cuts on its edge or one or more apertures for providing access to the control terminals of the semiconductor components in order to facilitate the connection of the wire bonds to the control terminals of the semiconductor components.

The electrical modules 360-365 can be, for example, according to what is described in figures 1a, 1b and 1c or in figures 2a and 2b and in the text passages related to these figures. The outer surfaces of the first and second substrate plates of the electrical modules 360-365 are pressed towards the electrical conductor elements 355-359 as illustrated in figure 3b for the electrical module 360. The semiconductor components of each of the electrical modules 360-365 may comprise, for example, one or more an insulated gate bipolar transistors (IGBT) and one or more diodes that are anti-parallel to the IGBTs.

The electrical converter device shown in figure 3a is a frequency converter. An electrical converter device according to an embodiment of the invention can be as well, for example but not necessarily, a mere inverter or a mere rectifier.

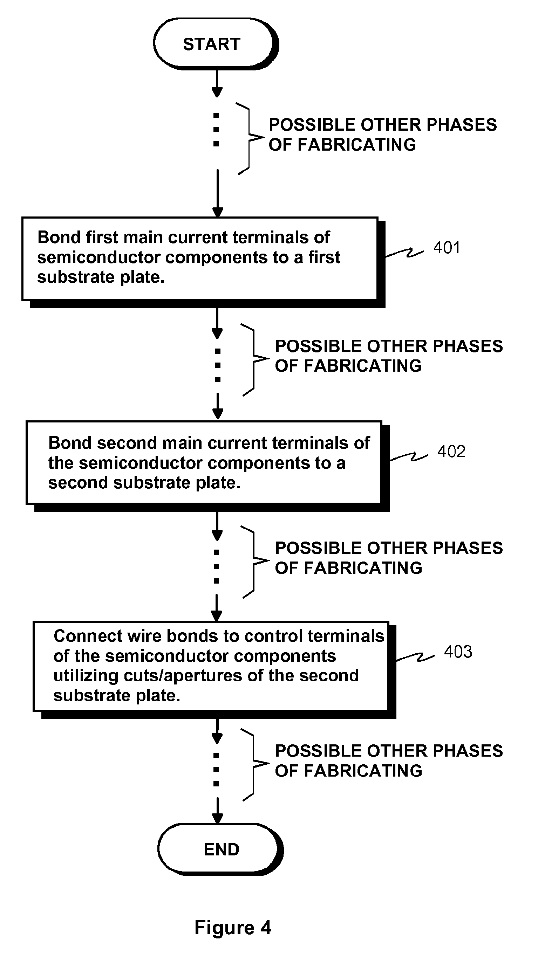

Figure 4 is a flow chart of a method according to an embodiment of the invention for fabricating an electrical module. The method comprises:
- bonding, in a method step 401, a first main current terminal of one or more semiconductor components to a first electrically conductive substrate plate,
- bonding, in a method step 402, a second main current terminal of the one or more semiconductor components to a second electrically conductive substrate plate, and subsequently
- connecting, in a method step 403, one or more wire bonds to control terminals of the semiconductor components,
   wherein the second substrate plate has one or more cuts on its edge or one or more apertures for providing access to the control terminals of the semiconductor components in order to facilitate the connection of the wire bonds to the control terminals of the semiconductor components.

In a method according to an embodiment of the invention, each of the semiconductor components is one of the following: an insulated gate bipolar transistor (IGBT), a field effect transistor (FET), a gate turn-off thyristor (GTO), a thyristor, or a diode.

In a method according to an embodiment of the invention, the one or more semiconductor components comprise one or more insulated gate bipolar transistors (IGBT), a collector of each IGBT representing the first main current terminal of that IGBT, an emitter of each IGBT representing the second main current terminal of that IGBT, and a gate of each IGBT representing the control terminal of that IGBT. The one or more semiconductor components may further comprise one or more diodes that are oriented to be anti-parallel to the IGBTs.

A method according to an embodiment of the invention further comprises bonding one or more wiring structures to the same side of the first substrate plate as the one or more semiconductor components and connecting the one or wire bonds to the wiring structures. Each of the wiring structures comprises an insulator layer and a metal strip on the insulator layer. The insulator layer of the wiring structure may comprise a metal strip/layer also on its side facing towards to first substrate plate for facilitating the bonding of the wiring structure to the first substrate plate. The second substrate plate has one or more cuts on its edge or one or more apertures for providing access to connection pads of the wiring structures in order to facilitate the connection of the wire bonds to the wiring structures.

In a method according to an embodiment of the invention, each of the one or more wiring structures is a direct copper bonding substrate.

In a method according to an embodiment of the invention, each of the one or more wiring structures is a printed circuit board.

In a method according to an embodiment of the invention, the second substrate plate has a shape of a rectangle from which corners have been removed and which has a cut also on the middle of one of its sides.

The specific examples provided in the description given above should not be construed as limiting. Therefore, the invention is not limited merely to the embodiments described above, many variants being possible.

## Claims

1. An electrical module comprising a first electrically conductive substrate plate (101, 201), a second electrically conductive substrate plate (102, 202), one or more semiconductor components (103-110, 203, 204) between the first and second substrate plates in such a manner that a first main current terminal of each semiconductor component is bonded to the first substrate plate and a second main current terminal of each semiconductor component is bonded to the second substrate plate, and one or more wire bonds (111, 112, 120, 121, 211) connected to control terminals of the semiconductor components, **characterized in that** the second substrate plate has one or more cuts (115, 116, 122, 123, 124) on its edge or one or more apertures (217) for providing access to the control terminals of the semiconductor components in order to facilitate the connection of the wire bonds to the control terminals of the semiconductor components.

2. An electrical module according to claim 1, wherein the electrical module further comprises one or more wiring structures (113) connected to the one or more wire bonds, each of the wiring structures comprising an insulator layer (114) and a metal strip (125) on the insulator layer and being bonded to the same side of the first substrate plate as the one or more semiconductor components and the second substrate plate having one or more cuts on its edge or one or more apertures for providing access to connection pads of the wiring structures in order to facilitate the connection of the wire bonds to the wiring structures.

3. An electrical module according to claim 1 or 2, wherein the second substrate plate (102) has a shape of a rectangle from which corners have been removed and which has a cut (116) on the middle of one of its sides.

4. An electrical module according to claim 2, wherein each of the one or more wiring structures is a direct copper bonding substrate.

5. An electrical module according to claim 2, wherein each of the one or more wiring structures is a printed circuit board.

6. An electrical module according to claim 1, wherein each of the semiconductor components is one of the following: an insulated gate bipolar transistor (IGBT), a field effect transistor (FET), a gate turn-off thyristor (GTO), a thyristor, a diode.

7. An electrical module according to claim 1, wherein the one or more semiconductor components comprise one or more an insulated gate bipolar transistors (IGBT), a collector of each insulated gate bipolar transistor representing the first main current terminal of that insulated gate bipolar transistor, an emitter of each insulated gate bipolar transistor representing the second main current terminal of that insulated gate bipolar transistor, and a gate of each insulated gate bipolar transistor representing the control terminal of that insulated gate bipolar transistor.

8. An electrical converter device, **characterized in that** the electrical converter device comprises at least one electrical module (360-365) according to claim 1.

9. A method for fabricating an electrical module, the method comprising:
- bonding (401) a first main current terminal of one or more semiconductor components to a first electrically conductive substrate plate,
- bonding (402) a second main current terminal of the one or more semiconductor components to a second electrically conductive substrate plate,
**characterized in that** the method further comprises connecting (403) one or more wire bonds to control terminals of the semiconductor components after the first and second main current terminals of the semiconductor components have been bonded to the first and second substrate plates, the second substrate plate having one or more cuts on its edge or one or more apertures for providing access to the control terminals of the semiconductor components in order to facilitate the connection of the wire bonds to the control terminals of the semiconductor components.

10. A method according to claim 9, wherein the method further comprises bonding one or more wiring structures to the same side of the first substrate plate as the one or more semiconductor components and connecting the one or wire bonds to the wiring structures, each of the wiring structures comprising an insulator layer and a metal strip on the insulator layer and the second substrate plate having one or more cuts on its edge or one or more apertures for providing access to connection pads of the wiring structures in order to facilitate the connection of the wire bonds to the wiring structures.

11. A method according to claim 9 or 10, wherein the second substrate plate has a shape of a rectangle from which corners have been removed and which has a cut on the middle of one of its sides.

12. A method according to claim 10, wherein each of the one or more wiring structures is a direct copper bonding substrate.

13. A method according to claim 10, wherein each of the one or more wiring structures is a printed circuit board.

14. A method according to claim 9, wherein each of the semiconductor components is one of the following: an insulated gate bipolar transistor (IGBT), a field effect transistor (FET), a gate turn-off thyristor (GTO), a thyristor, a diode.

15. A method according to claim 9, wherein the one or more semiconductor components comprise one or more an insulated gate bipolar transistors (IGBT), a collector of each insulated gate bipolar transistor representing the first main current terminal of that insulated gate bipolar transistor, an emitter of each insulated gate bipolar transistor representing the second main current terminal of that insulated gate bipolar transistor, and a gate of each insulated gate bipolar transistor representing the control terminal of that insulated gate bipolar transistor.
